Europäisches Patentamt

European Patent Office

Office européen des brevets

(11) Publication number: **0 233 823**
**A2**

(12) # EUROPEAN PATENT APPLICATION

(21) Application number: **87400346.0**

(22) Date of filing: **17.02.87**

(51) Int. Cl.³: **H 01 L 21/00**
**H 01 L 29/08**

(30) Priority: **17.02.86 JP 33237/86**
**17.02.86 JP 33236/86**

(43) Date of publication of application:
**26.08.87 Bulletin 87/35**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Takao, Miura**
**10-9, Kamijujo 5-chome Kita-ku**
**Tokyo 114(JP)**

(74) Representative: **Joly, Jean-Jacques et al,**
**CABINET BEAU DE LOMENIE 55, rue d'Amsterdam**
**F-75008 Paris(FR)**

(54) **Method for manufacturing a metal insulator semiconductor field effect transistor.**

(57) With an increase of integration density in an integrated circuit, the channel length of MIS FET becomes shorter and shorter, which causes a hot carrier effect. To solve this problem, the doping profile of source/drain regions and doping amount must be precisely controlled such that a strong electric field is not generated in a transition region from channel to drain. To obtain this result reflowed sidewalls (14B) of doped silicate glass having a gentle slope are formed on both sides of a gate electrode (13A), and the gate electrode and the sidewalls thus formed are used as a mask for ion implantation. The depth of ion implantation and the doping amount change gradually from the channel region to the drain region avoiding the generation of a strong electric field and thus alleviates the hot carrier effect. The present invention has also an effect of obtaining a passivation layer having a gentle slop on the surface and avoiding broken wire troubles in an aluminium wiring layer formed thereabove.

FIG. 8

This invention relates to a method for manufacturing an Insulated Gate or Metal Insulator Semiconductor (abbreviated hereinafter as MIS) Field Effect Transistor (abbreviated hereinafter as FET) formed in an integrated circuit having a high integration density. More particularly, this invention relates to an improvement in doping profiles for an active region of a MIS FET having a short channel length.

It is known that a short channel length in a FET structure causes fluctuations or defects of the FET characteristics with an increasing integration density. Changes in threshhold voltage, transconductance, breakdown voltage characteristic of a drain junction, or the like are caused by a punch-through phenomenon or a hot carrier effect generated in a channel region or its vicinity of the MIS FET. This invention is intended mainly to alleviate the above hot carrier effect.

Hot carrier effect is enhanced by a strong electric field existing in a depletion layer especially near the p-n junction surface of a drain region. Electrons, including those generated by impact ionization caused by a carrier electron, are accelerated toward a gate insulating film by the electric field and trapped in the gate insulating film resulting in a change of threshhold voltage and other characteristics. In order to solve this problem Lightly Doped Drain (abbreviated as LDD) technology has been utilized in the prior art.

In a LDD structure ion implantation is performed in such a way that carrier electrons travelling toward the drain region encounter a first p-n junction between a p-type substrate and an $n^-$ region and a second $n^- - n^+$ junction between the $n^-$ region and a $n^+$ region. The electric field strengths near the junction surfaces are then reduced compared with that formed near a $p-n^+$ junction in a conventional MIS FET structure.

However, the LDD structure requires an accurate control of the ion implantation process to obtain the suitable doping profile and impurity distribution.

In addition, the hot carrier effect cannot be completely avoided.

It is a main object of the invention to provide a method for manufacturing a MIS FET where the hot carrier effect is eliminated.

More particularly it is an object of the invention to provide a method by which a junction is formed between channel and drain regions such that no abrupt change in doping profile and impurity density is met along the trajectory of a carrier electron travelling from the source to the drain regions.

The above objects are achieved, according to the invention, by providing a method comprising the steps of:

(a) forming a gate insulating film and a gate electrode on a silicon substrate;

(b) forming a sidewall of reflowed insulating material on both sides of said gate electrode; and

(c) implanting impurity ions into said substrate to form source and drain regions of said MIS FET using said gate electrode and said sidewalls as a mask.

Silicate glass can be used as a reflowed material. A doped silicate glass, having a reflow temperature below 1100°C, may advantageously be utilized for this purpose. Phosphorus pentoxide $(P_2O_5)$ is widely used as doping material, and silicate glass doped with phosphorus pentoxide is well known as Phospho-Silicate-Glass (PSG). Other doping material such as an oxide of boron (B) or arsenic (As), or a combination of these oxides can also be used.

In order to form reflowed sidewalls, two methods may be carried out. The first method comprises the steps of depositing the insulating material of doped silicate glass on the entire surface of the substrate, next reflowing the doped silicate glass, and final etching to leave reflowed sidewalls of doped silicate glass. The second method differs from the first one in the order in which the steps are carried out: first, the insulating material of doped silicate glass is deposited on the entire surface of the substrate, next etching is performed anisotropically to leave sidewalls, and finally the sidewalls are reflowed.

The object of reflowing the doped silicate glass is to obtain a sidewall having a gentle sloped, almost a flat surface. As a result, sidewalls having a thickness which decreases linearly as the distance from a side of the gate electrode increases, are obtained.

When a substrate having a gate electrode and sidewalls such as described above is subjected to an impurity ion implantation, the depth of ion penetration into the substrate and the impurity density change almost linearly from a channel region to a source/drain region. A retrograded junction is thus formed between the channel and drain regions, which means that no distinct junction with an abrupt change in doping profile and impurity density is found from a p-type channel region to an $n^-$, n and then to an $n^+$ -type drain region. This doping profile reduces the generation of a local strong electric field and consequently contributes to alleviate a hot carrier effect.

Another advantage of the present invention resides in the fact that the gate electrode and reflowed sidewalls formed on both sides thereof do not show steep steps as usually encountered in a conventional gate structure of MIS FET. The passivation layer and the wiring layer thereabove can then be formed on a comparatively gentle sloped surface of the substrate and the gate electrode. This contributes to improve the flatness of the wiring layer, such as an aluminium wiring layer, and to reduce broken wire troubles during the formation of the wiring layer or the life of the FET.

It may be noted here that other methods of forming sidewalls are known, such as spin-coating the so-called Spin On Glass (abbreviated as SOG) or "Silanol" on the substrate, as disclosed in the Japanese Patent Applications Nos. 59-92573, by K.Mitsui, and 59-47769, by Y. Wada, et al. However, a spin-coated layer utilizing a liquid state coating material shows a concave shape outwardly, and lacks thickness uniformity, depending on the gate pattern or the chip location on the wafer.

Further objects and advantages of the present invention will be apparent from the following description, reference being made to the accompanying drawings wherein:

Figs.1 through 4 show cross-sectional views at successive steps of the fabrication of an LDD structure according to the prior art,

Figs.5 through 9 show cross-sectional views at successive steps of a fabrication process of a MIS FET in accordance with the present invention, a first method of forming reflowed sidewalls on both sides of gate electrode being carried out, and

Figs. 10 through 12 show cross-sectional views at principal steps of a fabrication process of a MIS FET in accordance with the present invention, a second method of forming reflowed sidewalls being carried out.

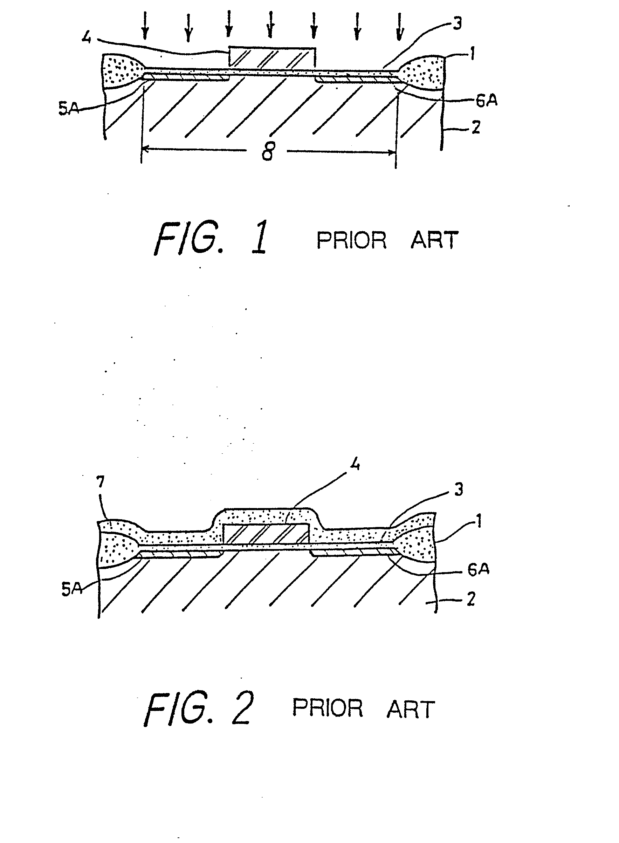

The fabrication process of a LDD structure according to the prior art will first be described with reference to Figs.1 to 4.

As shown in Fig.1, a gate insulating film 3 is formed on an active region 8 of a p-type silicon substrate 2, and the active region 8 is surrounded by a field oxide layer 1 and separated from other active elements. A polysilicon layer is deposited and patterned by a conventional photolithography technology, forming a gate electrode 4.

Next, phosphorous ions ($P^+$) or arsenic ions ($As^+$), having a comparatively low accelerating voltage and a low dose density, are implanted in a direction shown by the arrows using the gate electrode 4 as a mask, forming two $n^-$ regions 5A and 6A.

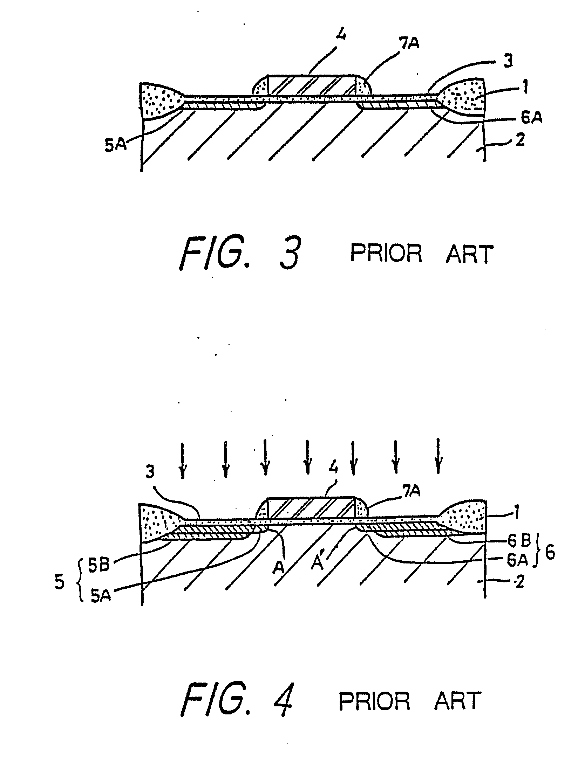

Then a silicon dioxide ($SiO_2$) layer 7 is deposited by CVD method as shown in Fig.2. The silicon dioxide layer 7 is subjected to a Reactive Ion Etching (abbreviated as RIE), to be etched anisotropically, so as to leave sidewalls 7A of silicon dioxide on both sides of gate electrode 4. This is shown in Fig.3.

Next, Fig. 4 shows implantation of the substrate with arsenic ions ($As^+$) having a high accelerating voltage and a high dose density, forming $n^+$ regions 5B and 6B. A source region 5 is formed by $n^-$ region 5A and $n^+$ region 5B, and a drain region 6 is formed by $n^-$ region 6A and $n^+$ region 6B.

In an LDD structure such as explained above, carrier electrons travelling toward drain region 6 encounter two junctions, a first p-n junction between the p-type substrate and the $n^-$ region 6A and a second $n^- -n^+$ junction between regions 6A and 6B. If the applied voltages for each electrode are the same, the electric field strengths near the junction surfaces are remarkably reduced compared with that formed near a $p-n^+$ junction in a conventional MIS FET structure.

The LDD structure above disclosed requires a strict control of the doping profile and impurity distribution. Moreover, the inside front periphery A and A' of $n^-$ regions 5A and 6A facing with each other in Fig.4 advances into the channel region after the subsequent annealing process, resulting in making an effective channel length shorter. Furthermore, a cross-section of the sidewall 7A in Fig.3 generally shows a convex shape outwardly, and the inside profile of the $n^+$ regions 5B and 6B also changes depending on the shape of the sidewalls 7A formed by the RIE method.

Further the two impurity regions (5A, 6A) and (5B, 6B) are affected by an ion implantation voltage and a doping amount.

Because the exact control on the above processes is rather a difficult problem, further improvementss have been required.

In addition, even if the above conditions are fulfilled, an abrupt change of electric field on a boundary surface between $n^-$ and $n^+$ regions cannot be avoided and the hot carrier effect cannot be completely eliminated.

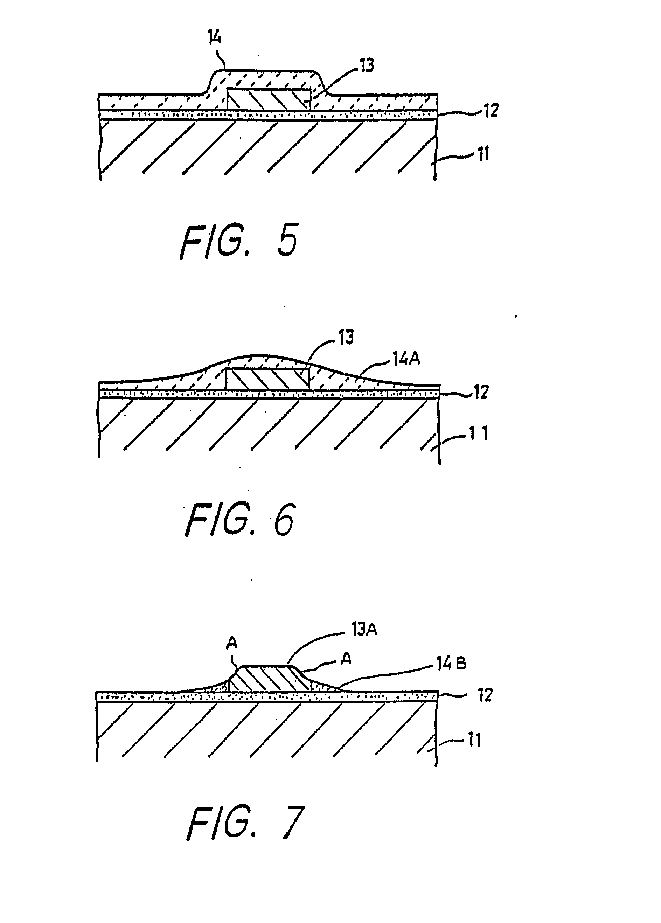

As a first embodiment of the present invention, a method including a first reflowing process for a doped silicate glass deposited on an entire surface, followed by an anisotropic etching process forming sidewalls, will now be explained with reference to Figs.5 through 9. In these Figures, a field oxide layer, which is not directly related with the present invention, is omitted.

As shown in Fig.5, a gate insulating film 12 is formed on a p-type silicon substrate 11 by a thermal oxidation method, and then a polysilicon layer is deposited and patterned by a conventional photolithography technology, forming a gate electrode 13. An insulating layer 14 of a doped silicate glass is deposited by CVD (Chemical Vapor Deposition) method.

As the material of the insulating layer 14, a silicate glass doped with an oxide of phosphorus (P) of boron (B), or of arsenic (As), or a combination thereof can be used.

In a case of depositing a Phospho-Silicate-Glass (PSG), namely a silicate glass containing phosphorus pentoxide ($P_2O_5$), a CVD method is used using monosilane ($SiH_4$), phosphine ($PH_3$), and oxygen ($O_2$) gases. the reflow temperature depends on the weight percentage of phosphorus pentoxide and on the flowability sought. Silicate glass having 8 to 12 weight percentage of phosphorus pentoxide has a reflow temperature ranging from 900 to 1050°C.

When a lower reflow temperature is required, oxides or boron, or of arsenic ($B_2O_5$ or $As_2O_3$ respectively), or a combination thereof can be used as doping material in the silicate glass.

The insulating layer 14 of PSG is reflowed in an inert gas environment at a temperature of 1000 to 1050°C to form a reflowed layer 14A on the substrate 11 as shown in Fig.6.

The substrate is next subjected to a RIE process using a gaseous mixture of carbon tetrafluoride ($CF_4$) and oxygen. This etching process is stopped when the reflowed glass on the gate electrode and source/drain regions has been removed, except in the vicinity of the gate electrode, leaving sidewalls on both sides of the gate electrode. Fig.7 shows the cross-sectional shape of the gate electrode and sidewalls when the RIE process is finished. As shown in this figure, both side edges A of the gate electrode 13A are partially removed and form continuous surfaces together with the reflowed sidewalls 14B, since polysilicon is also etched when the above RIE process is carried out.

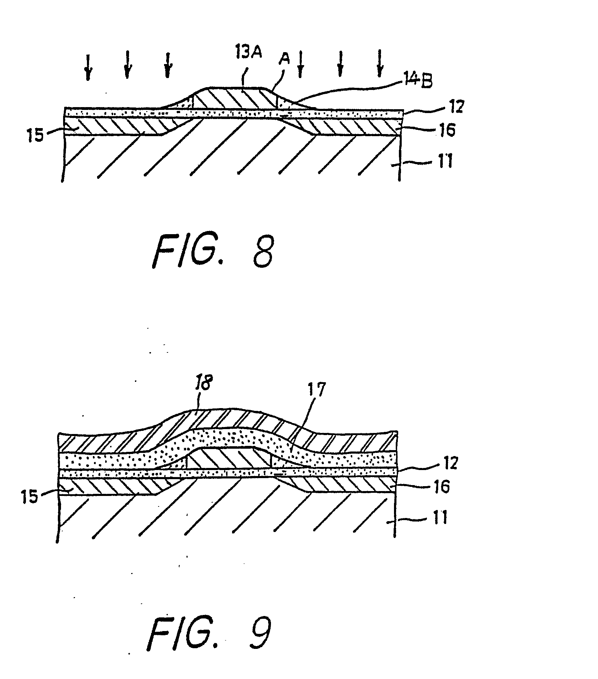

Then, impurity ions such as phosphorus or arsenic are implanted using gate electrode 13A and sidewalls 14B as a mask, and source region 15 and drain region 16 are formed, as shown in Fig.8.

The doping profile and the doping amount in the substrate under the sidewall 14B change gradually and linearly from a channel region to a source/drain region, forming a retrograded junction.

Fig.9 shows a passivation layer 17 and a wiring layer 18 of aluminium formed on the substrate by conventional processes.

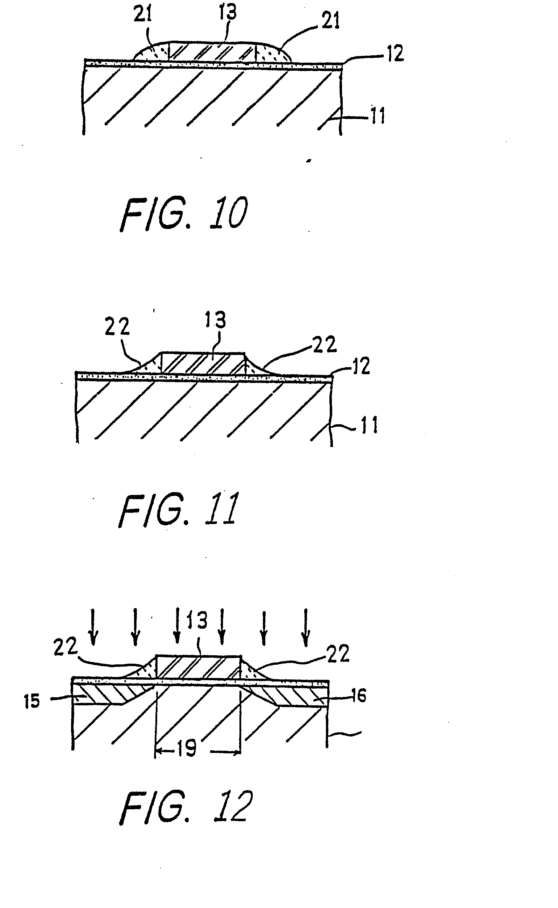

Another process of forming reflowed sidewalls will be explained with reference to Figs. 10 and 11. The first step is just the same as the one illustrated by Fig.5, wherein a gate insulating layer 12, a gate electrode 13, and an insulating layer 14 of doped silicate glass are formed on a p-type silicon substrate 11.

Subsequently, the substrate is subjected to an anisotroptic etching process, such as a RIE process, until the surface of the gate electrode 13 is exposed. At this stage, source/drain regions are partly exposed except the regions in the vicinity of the gate electrode, as shown in Fig.10.

A portion of the insulating layer 14 remains and forms sidewalls 21 on both sides of the gate electrode. Each sidewall 21 has a convex shape outwardly in cross-section due to RIE characteristics.

The sidewall 21 is reflowed in an inert gas environment at a temperature of approximately 1000°C. The reflow temperature is slightly lower than that applied in the reflowing process described with respect to Fig.6, because a small portion only of silicate glass is subjected to reflowing in this case.

After reflowing, each sidewall presents a comparatively gentle sloped surface, forming a reflowed sidewall 22 as illustrated by Fig.11.

Then, as shown in Fig.12, impurity ions such as phosphorus or arsenic ions are implanted using the gate electrode 13 and sidewalls 22 as a mask. Source region 15 and drain region 16 are formed in the substrate, and the depth of the ion penetration gradually increases along the direction from the channel region 19 under the gate electrode 13 to the source/drain regions not covered with the sidewalls.

Next, a passivation layer and wiring layer are formed thereon in the same way as the one shown in Fig.9.

In the above, only one step of ion implantation is carried out. However, when a different doping profile is required, a multi-step ion implantation technology may be used. For example, a first implantation of phosphorus ions is carried out before the deposition of the insulating layer 14 in Fig.5, and a second implantation of arsenic ions is performed after the reflowed sidewalls have been formed. A different doping profile can thus be obtained.

Another advantage of applying the present invention resides in that a passivation layer 17 is obtained without steep steps, because the gate electrode has a sidewall with a gentle slope on each side. Therefore, a reflow process for the passivation layer 17 is not necessary. Even if the passivation layer is subjected to a reflow process, the percentage of doped phosphorus pentoxide in silicate glass can be lowered compared with conventional MIS FET structures. As a result, broken wire troubles in an aluminium wiring layer formed on the passivation layer due to aluminium corrosion can be reduced remarkably, because the aluminium wiring is less chemically reactive with water and the phosphorus pentoxide contained in the passivation layer.

## CLAIMS

1.        A method of manufacturing MIS FET, said method comprising the steps of:

(a)  forming a gate insulating film and a gate  electrode on a silicon substrate;

(b)  forming a sidewall of reflowed insulating  material on both sides of said gate electrode; and

(c)  implanting impurity ions into said substrate to form source and drain regions of said MIS FET using said gate  electrode and said sidewalls as a mask.

2.        A method of manufacturing MIS FET according to claim  1, wherein said step (b) of forming a sidewall of reflowed  insulating material comprises the following sub-steps of:

(d)  depositing an insulating material on said  substrate and said gate electrode;

(e)  reflowing said insulating material; and

(f)  etching said reflowed insulating material until  the surface  of said gate electrode is exposed while a sloped  sidewall of  said  insulating  material is left on both sides  of  the  gate electrode.

3.        A method of manufacturing MIS FET according to claim  1, wherein said step (b) of forming a sidewall of reflowed  insulating material comprises the following sub-steps of:

(g)  depositing an insulating material on said  substrate and said gate electrode;

(h)  etching anisotropically said  insulating  material until  the  surface  of  said gate electrode  is  exposed  while  a sidewall portion of said insulating material is left on both  sides of the gate electrode; and

(i)  reflowing said insulating material.

4.        A method of manufacturing MIS FET according to any one of claims  1, 2 and 3, wherein said insulating material in steps  (b), (d), or (g) respectively is a doped silicate glass having a  reflow temperature below 1100°C.

5.        A method of manufacturing MIS FET according to claim  4, wherein said silicate glass is doped with an oxide of phosphorus (P) or boron (B) or arsenic (As), or a combination thereof.

6.      A method of manufacturing MIS FET according to claim 2, wherein said etching in step (f) is performed until the surface of said gate electrode is exposed and further the surface edge thereof is partly removed while a sloped sidewall of said insulating material is left on both sides of the gate electrode, thus forming a continuous curved surface.

## FIG. 1   PRIOR ART

## FIG. 2   PRIOR ART

*FIG. 3*   PRIOR ART

*FIG. 4*   PRIOR ART

FIG. 5

FIG. 6

FIG. 7

FIG. 8

FIG. 9

0233823

FIG. 10

FIG. 11

FIG. 12